(19) Europäisches Patentamt
European Patent Office
Office européen des brevets

(11) **EP 4 760 287 A1**

(12) **EUROPEAN PATENT APPLICATION**

(43) Date of publication:
**17.06.2026 Bulletin 2026/25**

(21) Application number: **24220066.5**

(22) Date of filing: **16.12.2024**

(51) International Patent Classification (IPC):
***G01R 31/327*** (2006.01)    ***G01R 31/28*** (2006.01)

(52) Cooperative Patent Classification (CPC):
**G01R 31/3277**; G01R 31/2827; G01R 31/2837

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ABB SCHWEIZ AG
5400 Baden (CH)**

(72) Inventors:
• **Salido Monzu, David
8047 Zürich (CH)**
• **Port, Andreas
8152 Opfikon (CH)**
• **Butti, Agostino
20151 Milano (IT)**
• **Ghezzi, Luca
21013 Gallarate (MI) (IT)**

(74) Representative: **De Bortoli, Eros et al
Zanoli & Giavarini S.p.A.
Via Melchiorre Gioia, 64
20125 Milano (IT)**

(54) **IMPROVED MONITORING SOLUTIONS FOR ELECTRICAL SYSTEMS**

(57)    The present invention relates to a method for probing a circuit breaker electrically connected to an electric line. The probing method comprises the following steps:
- injecting (101) a first signal ($S_1(t)$) at a first point (A) of said electric line, wherein said first signal has a predefined frequency content and a predefined frequency band and is injected during an injection time interval ($T_J$) having a predefined time duration;
- detecting (102) a second signal ($S_2(t)$) at a second point (B) of said electric line, wherein said second signal is detected during a detection time interval ($T_D$) including at least partially said injection time interval ($T_J$);
- processing (103) a first portion of said second signal ($S_2(t)$), which refers to a first portion ($T_J$) of said detection time interval ($T_D$), during which said first signal ($S_1(t)$) is injected, to calculate a first signal value ($G_{JR}$) indicative of the signal power of said second signal ($S_2(t)$) in the frequency band of said first signal $S_1(t)$, during the first portion ($T_J$) of said detection time interval ($T_D$);
- processing (104) a second portion of said second signal ($S_2(t)$), which refers to a second portion ($T_N$) of said detection time interval ($T_D$), during which said first signal ($S_1(t)$) is not injected, to calculate a second signal value ($G_N$) indicative of the signal power of said second signal ($S_2(t)$) in the frequency band of said first signal $S_1(t)$, during the second portion ($T_N$) of said detection time interval ($T_D$).

**FIG. 1**

**Description**

The present invention relates to the field of electrical systems, preferably operating at low-voltage levels. More particularly, the present invention relates to an improved method for probing a circuit breaker in an electrical system. The probing method, according to the invention, can be advantageously adopted in monitoring methods for determining an operating state of a circuit breaker. According to a further aspect, the present invention relates to a monitoring device for determining an operating state of a circuit breaker, which is configured to carry out the probing method of the invention.

Generally, low-voltage electrical systems, such as electrical installations at residential, commercial business or industrial sites, include a number of circuit breakers configured to implement protection functionalities of specific electrical lines or grid sections.

Normally, circuit breakers have standardized dimensions and are mounted on installation rails arranged in suitable electrical panels. Typically, these devices can take a closed state, at which an electrical current is allowed to flow along a corresponding electrical line, and a tripped state or open state, at which an electrical current flowing along said electrical line is interrupted. Nowadays, several applications, e.g., most recent smart-home systems or electrical installations including distribution and sub-distribution panels at different physical locations, require that the operating conditions of the installed circuit breakers be monitored in order to ensure a fast intervention in case of a fault.

Most traditional solutions designed for the purpose of monitoring the operating state of a circuit breaker foresee that a side accessory is mechanically coupled to the circuit breaker in order to switch together with this latter and signal the operating state of the circuit breaker through a suitable I/O interface. Unfortunately, these solutions may be difficult to employ (e.g., during retrofitting interventions) as an additional space in proximity of the circuit breaker has to be foreseen on the installation rails to allow the above-mentioned accessory device to be mounted. Patent documentEP4119959A1 discloses a device for monitoring the operating state of a circuit breaker in a low-voltage electrical system.

The monitoring device disclosed in the above-mentioned patent document is configured to probe the circuit breaker by injecting and detecting signals through the electric line, on which the circuit breaker is installed, and determine the operating status of the circuit breaker based on the detection signals acquired through the above-mentioned probing activity.

The monitoring device comprises a signal transceiver comprising a transmitter arrangement, which is operatively coupled to an electric line at a first point, and receiver arrangement, which is operatively coupled to said electric line, at a second point.

The transmitter arrangement is configured to generate a first signal and inject this latter into the electric line at the above-mentioned first point. The receiver arrangement is configured to receive a second signal from the electric line at the second point in response to the injection of the above-mentioned first signal by the transmitter arrangement.

The disclosed monitoring device further comprises a signal processor, which is operatively coupled to the signal transceiver and is configured to determine the state of the circuit breaker by suitably processing the second signal received by the receiver arrangement of the signal transceiver.

A remarkable advantage of the monitoring devices of this type consists in that they are characterised by a high flexibility in installation. In fact, they do not need to be mechanically coupled to a circuit breaker and, therefore, they do not have to be mounted on the installation rails in the immediate vicinity of the circuit breaker.

These monitoring devices can thus be installed in operating positions suitably selected depending on the physical configuration of the electrical panel, for example between the installation rails or on the top or bottom of the installed circuit breakers.

Notwithstanding the above, these monitoring devices have still some aspects to improve.

The performances of these monitoring devices are highly influenced by the background noise either injected from the grid (i.e. the main power line typically upstream from the circuit breaker with reference to the main direction of the electric power flow along the electric line) or generated by electric loads electrically connected to the electric line (typically downstream from the circuit breaker with reference to the main direction of the electric power flow along the electric line).

High noise levels having frequencies included in the frequency band of the injected signal can greatly contribute to increase the detected signal level and lead to an overestimation of this latter. The determination process of the operating state of the circuit breaker can thus lead to a wrong evaluation of the operating state of the circuit breaker, typically to a false positive determination of a closed state.

In the market, it is quite felt the need for innovative solutions able to overcome or mitigate the above-mentioned technical issues of these recent solutions of the state of the art.

The present invention intends to respond to this need by providing a method for probing a circuit breaker, according to the following claim 1 and the related dependent claims.

In a further aspect, the present invention relates to a method for monitoring an operating state of a circuit breaker, according to the following claim 8.

In a further aspect, the present invention relates to a device for monitoring an operating state of a circuit breaker, according to the following claim 9.

In yet a further aspect, the present invention relates to a low-voltage electrical system, according to the following claim 11.

Characteristics and advantages of the present invention will emerge more clearly from the description of preferred, but not exclusive embodiments of the probing method, according to the invention, of which non-limiting examples are shown in the attached drawings, wherein:

- figure 1 is a schematic view showing an electrical system including a circuit breaker and a monitored device operatively associated to said circuit breaker and capable of carrying out the monitoring method of the invention;
- figures 2, 2A, 2B, 2C, 3 are schematic diagrams showing the operating steps of the probing method of the invention;
- figures 4-5 are schematic diagrams showing the operating steps of a monitoring method of the operating state of a circuit breaker, which includes the probing method of the invention.

With reference to the above-mentioned figures, the present invention concerns improved monitoring solutions for electrical systems (e.g. electric grids, electric switchgear systems, electric switchboards, and the like), which preferably operate at low-voltage levels, i.e. at voltage levels lower than 1,5 kV AC and 2,0 kV DC.

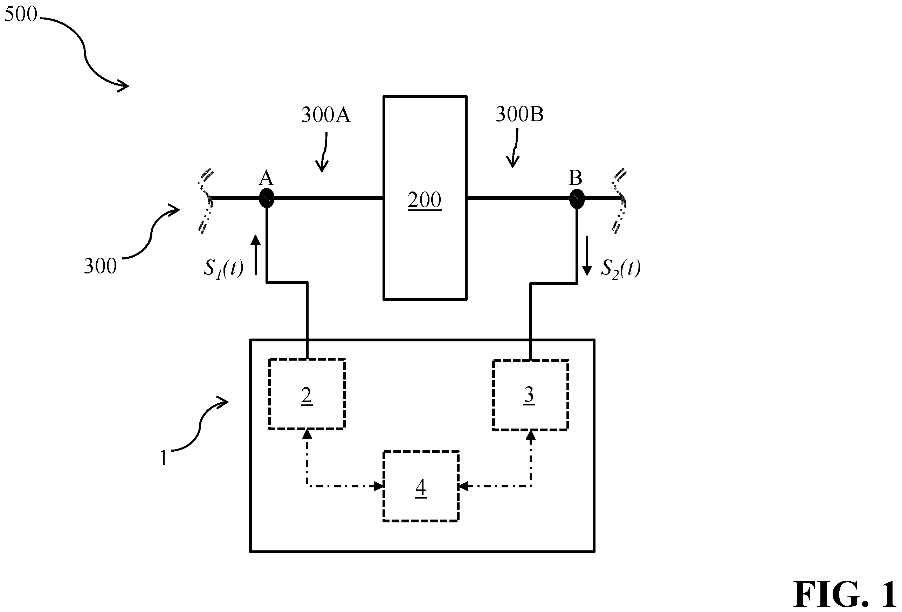

Figure 1 shows an exemplary electrical system 500 operating at low-voltage levels.

The electrical system 500 comprises a low-voltage electric line 300, which is intended to connect electrically two different grid sections, each of which may include one or more electric power sources and/or one or more electric loads.

The electric line 300 can comprise one or more phase conductors and, possibly, also a neutral conductor. As an example, the electric line 300 may be arranged according to a 1P+N configuration, a 3P configuration, a 3P+N configuration, or a 2P+N configuration.

The electrical system 500 comprises a circuit breaker 200 operatively coupled to the electric line 300. Namely, the circuit breaker 200 is electrically connected between a first line section 300A and a second line section 300B of the electric line 300.

The circuit breaker 200 may be of any type adapted for the employment in an electrical system operating at AC or DC low-voltage levels. For example, it may be a MCB (Miniature Circuit Breaker), a RCCB (Residual Current Circuit Breaker) device, or a RCBO (Residual Current circuit Breaker with Overcurrent protection) device, or a RCM (Residual Current Monitor) device, or the like.

In operation, the circuit breaker 200 can take a closed state, at which it allows the flow of a current along the electric line 300, or can take an open or tripped state, at which it prevents a current to flow along the electric line 300.

A transition from a closed state to an open or tripped state forms an opening manoeuvre or a tripping manoeuvre of the circuit breaker 200 while a transition from an open or tripped state to a closed state forms a closing manoeuvre of the circuit breaker.

Depending on how the electrical system 500 is configured, the energy flow along the electric line 300 can be directed from the first line section 300A to the second line section 300B, or vice-versa. For the circuit breaker 200, each of the line sections 300A, 300B may thus be considered as an input power supply line or an output power supply line depending on the main direction of the electric power flow.

In general, the electric line 300 and the circuit breaker 200 of the electrical system 500 may be realized according to solutions of known type. In the following, these elements will thus not be described in more details for the sake of brevity.

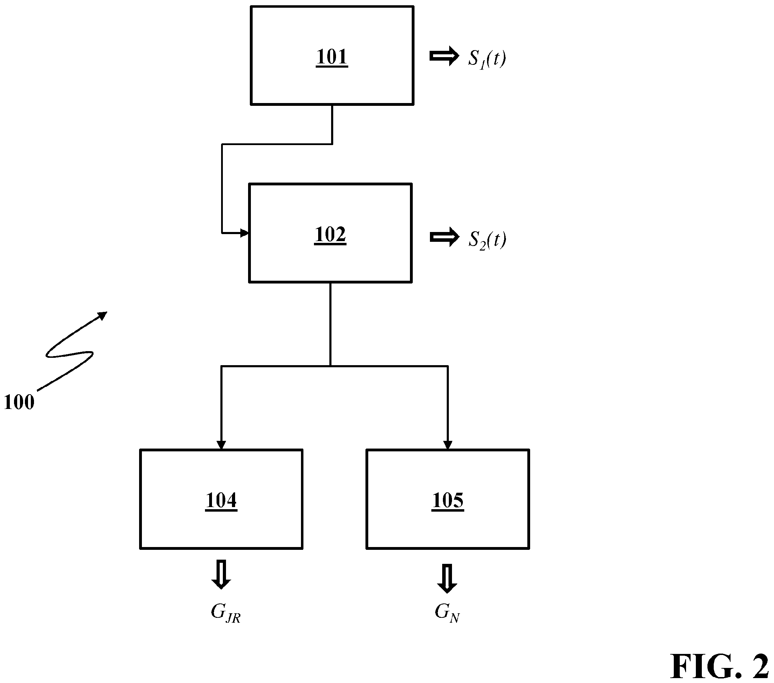

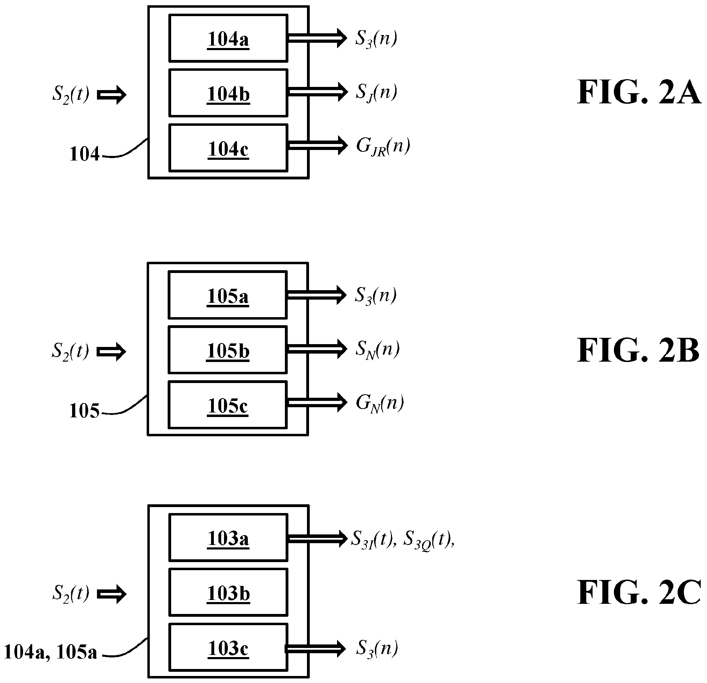

Referring now to figure 2, the present invention relates to an improved probing method 100 of a circuit breaker in an electrical system.

According to the invention, the probing method 100 comprises a step 101, in which a first signal $S_1(t)$ is generated and injected at a first point A (injection point) of the electric line 300.

In the embodiment shown in figure 1, the first point A, at which the first signal $S_1(t)$ is injected, is located at the first line section 300A of the electric line. In principle, however, it can be positioned also at the second line section 300B of the electric line.

Preferably, the first signal $S_1(t)$ is an AC signal.

Preferably, the first signal $S_1(t)$ is a current or voltage signal having a high frequency content (compared to the mains frequency), for example in the order of MHz.

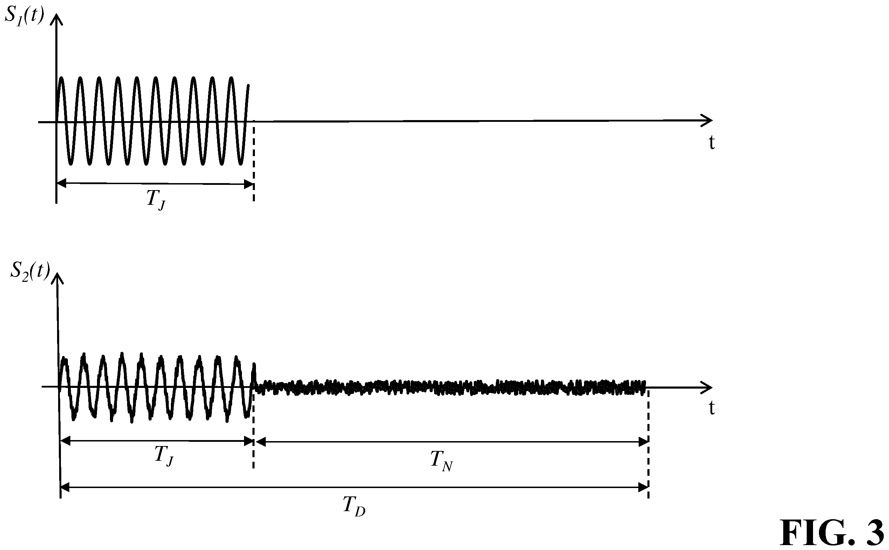

The first signal $S_1(t)$ has predefined centre frequency value and frequency band, and it is injected during an injection time interval $T_J$ having a predefined time duration (figure 3).

As an example, the first signal $S_1(t)$ may be a windowed sinusoidal signal having a frequency value of 1 MHz and injected for an injection time interval $T_J$ = 10 ms.

According to the invention, the probing method 100 comprises a step 102, in which a second signal $S_2(t)$ is detected at a second point B (detection point) of the electric line 300.

In the embodiment shown in figure 1, the second point B, at which the second signal $S_2(t)$ is detected, is located at the second line section 300B of the electric line. In principle, however, it can be positioned also at the first line section 300A of the electric line.

Preferably, the second signal $S_2(t)$ is an AC signal.

Preferably, the second signal $S_2(t)$ is a current or voltage signal having a high frequency content (compared to the mains frequency), for example in the order of MHz.

The second signal $S_2(t)$ is detected for a detection time interval $T_D$, which at least partially includes the injection time interval $T_J$ (figure 3).

Preferably, the injection of the first signal $S_1(t)$ and the detection of the second signal $S_2(t)$ are synchronized, for example through a suitable synchronization or event detection method (which may be of known type), so that the injection time interval $T_J$ is included in the detection time interval $T_D$.

Preferably, the detection time interval $T_D$ can be expressed as:

$$T_D = T_J + T_N$$

where $T_J$ is a first portion of the detection time interval $T_D$, during which the first signal $S_1(t)$ is injected, and $T_N$ is a second portion of the detection time interval $T_D$, during which the first signal $S_1(t)$ is not injected.

In principle, however, the injection time interval $T_J$ may start at any time during the detection time interval $T_D$. Consequently, the above-mentioned time portions $T_J$, $T_N$ of the detection time interval $T_D$ can be arbitrarily foreseen during the detection time interval $T_D$ provided that they do not overlap each other and are covered by the detection time interval $T_D$.

According to the invention, the probing method 100 comprises a step 104 of processing a first portion of the second signal $S_2(t)$, which refers to the first portion $T_J$ of the detection time interval $T_D$, during which the first signal $S_1(t)$ is injected, to calculate a first signal value $G_{JR}$ indicative of the signal power of the second signal $S_2(t)$ in the frequency band of the first signal $S_1(t)$, during the first portion $T_J$ of the detection time interval $T_D$.

The first signal value $G_{JR}$ is indicative of the magnitude of the signal components provided by the electric line in response to the injection of the first signal $S_1(t)$. In accordance with the above, the calculated first signal value $G_{JR}$ depends on both the operating state of the circuit breaker 200 and the background noise of the electric line 300.

According to the invention, the probing method 100 comprises a step 105 of processing a second portion of the second signal $S_2(t)$, which refers to the second portion $T_N$ of the detection time interval $T_D$, during which the first signal $S_1(t)$ is not injected, to calculate a second signal value $G_N$ indicative of the signal power of the second signal $S_2(t)$ in the frequency band of the first signal $S_1(t)$, during the second portion $T_N$ of the detection time interval $T_D$.

The second signal value $G_N$ is indicative of the magnitude of the background noise of the electric line, which depends on a number of factors such as the layout and type of the electric loads electrically connected to the electric line.

The calculation of the above-mentioned quantities $G_{JR}$, $G_N$ allows decorrelating signal components, which are useful to determine the operating state of the monitored circuit breaker from the undesired background noise of the electric line 300. The operating state of the circuit breaker 200 can thus be estimated based on the calculation of these quantities.

In principle, the above-mentioned steps 104, 105 of the method of the invention can be carried out through analog or digital signal processing means, according to the needs.

Preferably, they are carried out exploiting digital signal processing resources. In this case, the above-mentioned steps 104, 105 of the method of the invention advantageously includes the sub-steps described in figures 2A, 2B, 2C.

Preferably, the step 104 of the method 100 comprises a sub-step 104a of processing the detected second signal $S_2(t)$ to obtain a digital signal $S_3(n)$ indicative of the magnitude of the second signal $S_2(t)$ in the frequency band of the injected first signal $S_1(t)$.

Preferably, the step 104 of the method 100 comprises a sub-step 104b of selecting a first time-series $S_J(n)$ of signal samples from the calculated digital signal $S_3(n)$. The first time-series $S_J(n)$ of signal samples refers to time instants included in the first portion $T_J$ of the detection time interval $T_D$, during which the first signal $S_1(t)$ is injected.

The first time series $S_J(n)$ of signal samples allows observing the signal level provided by the electric line 300 in response to the injection of the first signal $S_1(t)$. During this portion of the detection time interval $T_D$, however, both signal components useful to determine the operating state of the circuit breaker and the background noise of the electric line are overlapped, and the background noise can greatly contribute to the detected signal level.

Preferably, the step 104 of the method 100 comprises a sub-step 104c of processing the first time-series $S_J(n)$ of signal samples to calculate a first signal value $G_{JR}$ indicative of the signal power of the second signal $S_2(t)$ in the frequency band of the first signal $S_1(t)$, during the first portion $T_J$ of the detection time interval $T_D$.

As mentioned above, the first signal value $G_{JR}$ is indicative of the signal power of the signal components provided by the electric line in response to the injection of the first signal $S_1(t)$. In accordance with the above, the calculated first signal value $G_{JR}$ depends on both the operating state of the circuit breaker 200 and the background noise of the electric line 300.

Preferably, the first signal value $G_{JR}$ is calculated as a statistical quantity (e.g., average power) indicative of the signal power of the first time-series $S_J(n)$ of signal samples. To this aim, well known signal processing techniques can be adopted.

For example, when the second signal $S_2(t)$ is demodulated through an I/Q demodulation process, the signal value $G_{JR}$ of the electric line may be calculated based on the following relationship:

$$G_{JR} = \frac{1}{P}\sum_{i=1}^{P}\sqrt{x_{3I}(i)^2 + x_{3Q}(i)^2}$$

where $x_{3I}(i)$, $x_{3Q}(i)$ are a generic pair of signal samples of the digital signal $S_J(n)$ and P is the number of pairs of signal samples included in the first time-series $S_J(n)$.

Preferably, the step 105 of the method 100 comprises a sub-step 105a of processing the detected second signal $S_2(t)$ to obtain a digital signal $S_3(n)$ indicative of the magnitude of the second signal $S_2(t)$ in the frequency band of the injected first signal $S_1(t)$.

Preferably, the step 105 of the method 100 comprises a sub-step 105b of selecting a second time-series $S_N(n)$ of signal samples from the calculated digital signal $S_3(n)$.

The second time-series $S_N(n)$ of signal samples refers to time instants included in the portion $T_N$ of the detection time interval $T_D$, during which the first signal $S_1(t)$ is not injected.

During the portion $T_N$ of the detection time interval $T_D$, the injection of the first signal $S_1(t)$ is terminated and the detected second signal $S_2(t)$ is formed by the sole background noise of the electric line. The second time series $S_N(n)$ of signal samples thus allows observing the background noise level of the electric line 300 in a frequency band corresponding to the frequency band of the first signal $S_1(t)$.

Preferably, the step 105 of the method 100 comprises a sub-step 105c of processing the second time-series $S_N$ of signal samples to calculate a second signal value $G_N$ indicative of the signal power of the second signal $S_2(t)$ in the frequency band of the first signal $S_1(t)$, during the second portion $T_N$ of the detection time interval $T_D$.

As mentioned above, the second signal value $G_N$ is indicative of the magnitude of the background noise of the electric line, which depends on a number of factors such as the layout and type of the electric loads electrically connected to the electric line.

Preferably, the background noise level $G_N$ is calculated as a statistical quantity (e.g., standard deviation) indicative of the variability of the second time-series $S_N(n)$ of signal samples, which is indicative of the background noise average power.

In order to calculate this quantity, well known signal processing techniques can also be adopted. For example, when the second signal $S_2(t)$ is demodulated through an I/Q demodulation process, a second signal value $G_N$ related to the electric line may be calculated based on one of the following relationships:

$$G_N = \sqrt{\sum_{i=1}^{M}\frac{1}{M}(x_{3I}(i) - x_0)^2} \ \text{ or } \ G_N = \sqrt{\sum_{i=1}^{M}\frac{1}{M}(x_{3Q}(i) - x_0)^2}$$

where $x_{3I}(i)$, $x_{3Q}(i)$ are a generic pair of signal samples of the digital signal $S_N(n)$, $x_0$ is the average value of $S_N(n)$ and M is the number of pairs of signal samples included in the second time-series $S_N$.

As mentioned above, being carried out through digital signal processing resources, the steps 104, 105 of the method 100 comprise respectively the sub-steps 104a, 105a of processing the detected second signal $S_2(t)$ to obtain a digital signal $S_3(n)$ indicative of the magnitude of the second signal $S_2(t)$ in the frequency band of the injected first signal $S_1(t)$.

Preferably, the above-mentioned sub-steps 104a, 105a comprise the sub-step 103a of calculating a pair of signals $S_{3I}(t)$, $S_{3Q}(t)$ by demodulating the detected second signal $S_2(t)$. The demodulation of the second signal $S_2(t)$ can be carried out according to well-known signal processing techniques, for example according to an I/Q demodulation process.

In this case, the pair of signals $S_{3I}(t)$, $S_{3Q}(t)$ are sinusoidal signals in quadrature representing down converted versions of the second signal $S_2(t)$, which are calculated by multiplying this last signal by suitable reference sinusoidal signals mutually in quadrature and having a predefined frequency.

Preferably, the above-mentioned sub-steps 104a, 105a comprise the sub-step 103b of filtering the calculated pair of signals $S_{3I}(t)$, $S_{3Q}(t)$ with a filter having a bandwidth narrow with respect to the centre frequency of the first signal $Si(t)$.

Preferably, the above-mentioned filter has a bandwidth $B_w < \frac{1}{10}f_c$, where $f_c$ is the centre frequency of the first signal $S_1(t)$.

As the pair of signals $S_{3I}(t)$, $S_{3Q}(t)$ are obtained by multiplying the detected second signal $S_2(t)$ with suitable frequency reference signals (demodulation), filtering is needed to discard spurious frequency components resulting from this mixing.

The filtering process of the signals $S_{3I}(t)$, $S_{3Q}(t)$ can be also carried out according to well-known signal processing techniques, for example according to band-pass or low-pass filtering process. Preferably, the above-mentioned sub-steps 104a, 105a comprise the sub-step 103c of sampling the filtered signals $S_{3I}(t)$, $S_{3Q}(t)$ so obtained with a sampling rate that basically depends on the centre frequency of the first signal $S_1(t)$.

More precisely, the sampling rate is calculated based on a down converted frequency, which is defined by the relationship between the centre frequency of the first signal $S_1(t)$ and the frequency of the reference signals used to demodulate the second signal $S_2(t)$. The sampling process of the filtered signals $S_{3I}(t)$, $S_{3Q}(t)$ can be also carried out according to well-known signal processing techniques.

It is apparent from the above how the digital signal $S_3(n)$ includes a pair of samples $x_{3I}(i)$, $x_{3Q}(i)$ at each generic $i_{th}$-instant (sampling instant). Each pair of samples $x_{3I}(i)$, $x_{3Q}(i)$ is obtained by sampling the filtered signals $S_{3I}(t)$, $S_{3Q}(t)$, which are in turn obtained by demodulating the detected second signal $S_2(t)$.

The digital signal $S_3(n)$ so obtained is thus indicative of the magnitude of the second signal $S_2(t)$ in the frequency band of the first signal $S_1(t)$.

As mentioned above, the calculation of the above-mentioned quantities $G_{JR}$, $Grv$ allows estimating the operating state of the circuit breaker 200.

The probing method 100 of the invention can be advantageously employed in methods for monitoring the state of a circuit breaker to collect information indicative of the operating state of this latter.

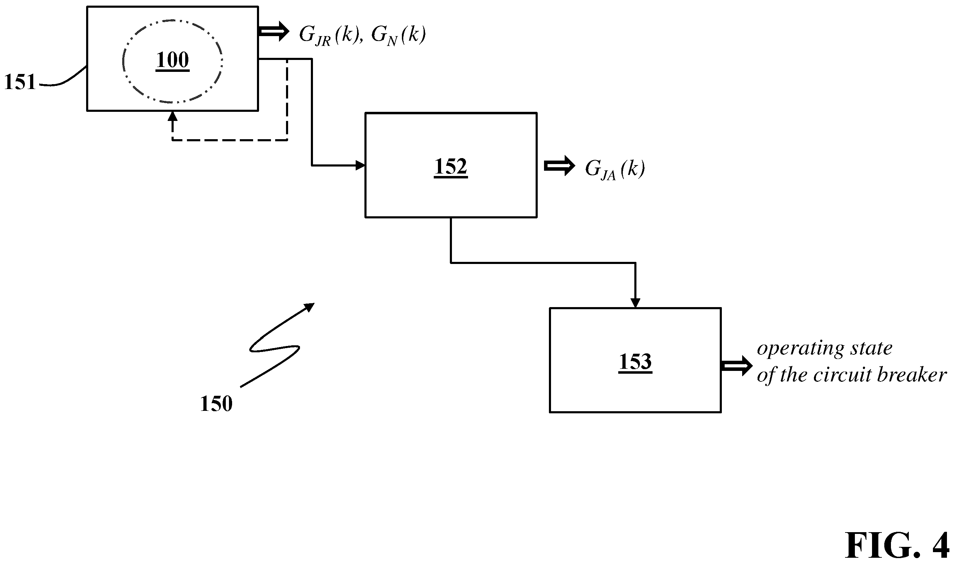

Figure 4 shows an exemplary preferred embodiment of a method 150 for monitoring the operating state of a circuit breaker.

The monitoring method 150 comprises a step 151 of repeating cyclically the probing method 100 of the invention to calculate a sequence of first signal values $G_{JR}(k)$ and a sequence of second signal values $G_N(k)$ related to the electric line 300 at subsequent instants in time.

The monitoring method 150 then comprises processing the calculated sequences of first signal values $G_{JR}(k)$ and second signal values $G_N(k)$ to determine an operating state of the circuit breaker.

Preferably, the monitoring method 150 comprises the processing step 152 of calculating a sequence of adjusted signal values $G_{JA}(k)$ related to the electric line based on the above-mentioned sequences of first signal values $G_{JR}(k)$ and second signal values $G_N(k)$, which are calculated by cyclically carrying out the probing method 100 of the invention.

An adjusted signal value $G_{JA}(k)$ of the electric line at a generic $k_{th}$-cycle may be simply calculated based on the following relationship:

$$G_{JA}(k) = G_{JR}(k) - G_N(k)$$

where $G_{JR}(k)$, $G_N(k)$ are the above-mentioned first signal value and second signal value at the same generic $k_{th}$-cycle, which may be calculated as illustrated above.

The sequence of adjusted signal values $G_{JA}(k)$ is indicative of the magnitude of the sole signal components provided by the electric line in response to the injection of the first signal $S_1(t)$, which are useful to determine the operating state of the circuit breaker.

Each adjusted signal value $G_{JA}(k)$ of the electric line is a quantity that basically depends on the operating state of the circuit breaker during the time when the measurement cycle k was carried out. Such a quantity is substantially immune from the background noise of the electric line. Therefore, the calculated sequence of adjusted signal values $G_{JA}(k)$ can be used for monitoring the behaviour of the circuit breaker in a robust and reliable manner.

Preferably, the monitoring method 150 comprises the processing step 153 of comparing the calculated sequence of adjusted signal values $G_{JA}(k)$ with one or more threshold values $V_{TH1}$, $V_{TH2}$ to determine the operating state of the circuit breaker. Based on the result of this comparison, the operating state of the circuit breaker can be determined.

Preferably, said threshold values are predefined. As an example, they can be derived from reference data acquired in controlled conditions with known breaker statuses.

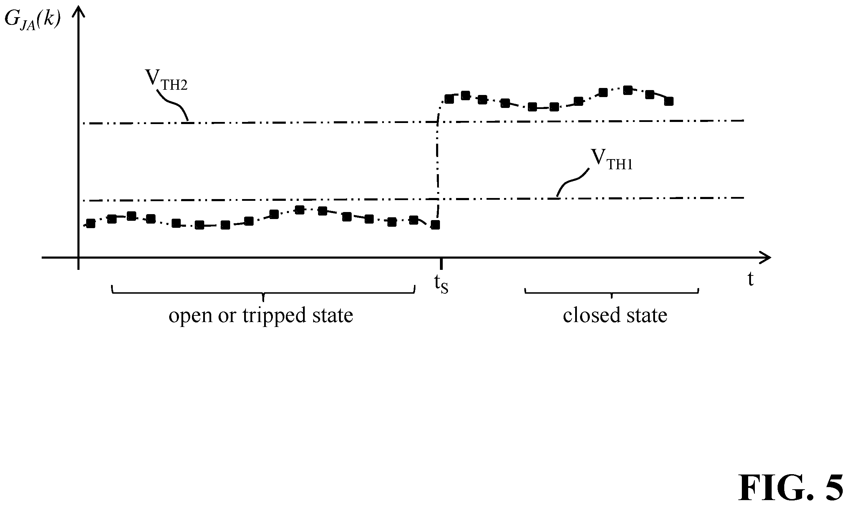

Figure 5 shows an exemplary representation of a sequence of adjusted signal values $G_{JA}(k)$ obtained during the execution of a closing manoeuvre by the circuit breaker 200 shown in the above-mentioned figure 1.

As it is possible to notice, the calculated adjusted signal values $G_{JA}(k)$ are relatively low before the switching instant ts (circuit breaker in an open or tripped state) and are relatively high after the switching instant ts (circuit breaker in a closed state).

By comparing the calculated adjusted signal values $G_{JA}(k)$ with a lower threshold value $V_{TH1}$ and with a higher threshold value $V_{TH2}$, it is possible to determine the operating state of the circuit breaker.

According to other embodiments of the invention, the above-mentioned sequences of first signal values $G_{JR}(k)$ and second signal values $G_N(k)$, which are calculated by cyclically carrying out the probing method 100 of the invention, are processed through suitable two-dimensional classification methods.

For example, each pair of first signal values $G_{JR}(k)$ and second signal values $G_N(k)$ can be interpreted as coordinates in a two-dimensional plane. A threshold value can be defined in this plane based on reference data acquired in controlled conditions with known breaker statuses, thus dividing the two-dimensional space into two sub-planes. By evaluating in which of these sub-planes the coordinates defined by $G_{JR}(k)$ and $G_N(k)$ reside, the operating state of the circuit breaker can be determined.

In a further aspect, the present invention relates to a monitoring device 1 for monitoring an operating state of the circuit breaker 200.

Referring back to figure 1, the monitoring device 1 preferably comprises a signal transceiver module 2, 3 and a signal processor module 4.

The signal transceiver module comprises a transmitter arrangement 2, which is operatively coupled (e.g., in a capacitive or inductive manner) to the electric line 300 at the first point A of this latter, and a receiver arrangement 3, which is operatively coupled (e.g. in a capacitive or inductive manner) to the electric line 300, at the second point B of this latter.

The signal processor module 4 is operatively coupled with the signal transmitter arrangement 2 and the receiver arrangement 3 in such a way to exchange data signals and command signals with both.

In many aspects, the monitoring device 1 can be realized industrially according to solutions of known type, for example according to the solutions described in the above-mentioned patent document EP4119959A1.

However, the monitoring device 1 is equipped with signal processing means (which may be of digital and/or analog type) configured to carry out the probing method 100 of the invention described above.

In some embodiments, the monitoring device 1 is equipped also with signal processing means (which may be of digital and/or analog type) configured to carry out the monitoring method 150 described above.

In an electrical system 500 (AC or DC), the monitoring device 1 can be mounted onboard or integrated in the circuit breaker 200 or constitute a separate unit from this latter. In this case, the monitoring device 1 does not need to be mounted in the immediate vicinity of the circuit breaker but it can be advantageously mounted in a suitable position within an electrical switchboard or panel.

It has been seen in practice how the monitoring solutions provided by the present invention provide relevant technical advantages over the state of the art.

The probing method, according to the invention, allows collecting information indicative of the operating state of the circuit breaker, which is substantially decorrelated from the background noise of the electric line on which the circuit breaker is mounted.

This allows monitoring the operating state of a circuit breaker in a robust and reliable manner, substantially independent from the background noise injected from the grid or generated by the electric loads electrically connected to the electric line.

The solution proposed by the claimed invention can therefore be employed in a monitoring method or monitoring device to allow a more efficient and safer determination process of the operating state of a circuit breaker, which reduces the risk that faults or malfunctions of the electrical system remain unattended and favours the execution of urgent interventions in case of faults.

The probing method, according to the invention, requires relatively small computational resources to be carried out and is relatively easy and cheap to implement at industrial level. The monitoring method and the monitoring device, according to the invention, are also relatively easy to implement at industrial level at competitive costs with currently available solutions of the state of the art.

**Claims**

1. Method (100) for probing a circuit breaker (200), wherein said circuit breaker is electrically connected to an electric line (300), **characterised in that** said method comprises the following steps:

   - injecting (101) a first signal ($S_1(t)$) at a first point (A) of said electric line, wherein said first signal has a predefined frequency content and a predefined frequency band and is injected during an injection time interval ($T_J$) having a predefined time duration;
   - detecting (102) a second signal ($S_2(t)$) at a second point (B) of said electric line, wherein said second signal is detected during a detection time interval ($T_D$) including at least partially said injection time interval ($T_J$);
   - processing (104) a first portion of said second signal ($S_2(t)$), which refers to a first portion ($T_J$) of said detection time interval ($T_D$) during which said first signal ($S_1(t)$) is injected, to calculate a first signal value ($G_{JR}$) indicative of the signal power of said second signal ($S_2(t)$) in the frequency band of said first signal $S_1(t)$, during the first portion ($T_J$) of said detection time interval ($T_D$);
   - processing (105) a second portion of said second signal ($S_2(t)$), which refers to a second portion ($T_N$) of said detection time interval ($T_D$) during which said first signal ($S_1(t)$) is not injected, to calculate a second signal value ($G_N$) indicative of the signal power of said second signal ($S_2(t)$) in the frequency band of said first signal $S_1(t)$,

during the second portion ($T_N$) of said detection time interval ($T_D$).

2. Method, according to claim 1, **characterised in that** said step (104) of processing a first portion of said second signal ($S_2(t)$) comprises the following sub-steps:

- processing (104a) said second signal ($S_2(t)$) to obtain a digital signal $S_3(n)$ indicative of the magnitude of said second signal $S_2(t)$ in the frequency band of said first signal $S_1(t)$;
- selecting (104b) a first time-series ($S_J(n)$) of signal samples from said digital signal ($S_3(n)$), wherein said first time-series of signal samples refers to the first portion ($T_J$) of said detection time interval ($T_D$), during which said first signal ($S_1(t)$) is injected;
- processing (104c) said first time-series ($S_J(n)$) of signal samples to calculate said first signal value ($G_{JR}$).

3. Method, according to one of the previous claims, **characterised in that** said step (105) of processing a second portion of said second signal ($S_2(t)$) comprises the following sub-steps:

- processing (105a) said second signal ($S_2(t)$) to obtain a digital signal $S_3(n)$ indicative of the magnitude of said second signal $S_2(t)$ in the frequency band of said first signal $S_I(t)$;
- selecting (105b) a second time-series ($S_N(n)$) of signal samples from said digital signal ($S_3(n)$), wherein said second time-series of signal samples refers to the second portion ($T_N$) of said detection time interval ($T_D$), during which said first signal ($S_1(t)$) is not injected;
- processing (105c) said second time-series ($S_N(n)$) of signal samples to calculate said second signal value ($G_N$).

4. Method, according to claim 2 or 3, **characterised in that** said step (104a, 105a) of processing said second signal ($S_2(t)$) to obtain a digital signal ($S_3(n)$) comprises the following sub-steps:

- calculating (103a) a pair of signals ($S_{3I}(t)$, $S_{3Q}(t)$,) by demodulating said second signal ($S_2(t)$);
- filtering (103b) said pair of signals ($S_{3I}(t)$, $S_{3Q}(t)$,) with a filter having a bandwidth that is narrow in comparison to the predefined centre frequency of said first signal ($S_1(t)$);
- sampling (103c) the filtered pair of signals ($S_{3I}(t)$, $S_{3Q}(t)$,) with a sampling rate that depends on the centre frequency of said first signal ($S_1(t)$).

5. Method, according to claim 4, **characterised in that** said second signal ($S_2(t)$) is demodulated through an I/Q demodulation process.

6. Method, according to one of the previous claims, **characterised in that** said first signal value ($G_{JR}$) is calculated as a statistical quantity indicative of the signal power of said first time-series ($S_J(n)$) of signal samples.

7. Method, according to one of the previous claims, **characterised in that** said second signal value ($G_N$) is calculated as a statistical quantity indicative of the signal power of said second time-series ($S_N(n)$) of signal samples.

8. Method (100) for monitoring an operating state of a circuit breaker (200) electrically connected to an electric line (300), **characterised in that** said method comprises the following steps:

- repeating cyclically (151) a probing method (100), according to one of the previous claims, to calculate a sequence of first signal values ($G_{JR}(k)$) and a sequence of second signal values ($G_N(k)$) at subsequent time instants.
- processing (152, 153) the calculated sequences of first and second signal values ($G_{JR}(k)$, $G_N(k)$) to determine an operating state of said circuit breaker (200).

9. A monitoring device (1) for monitoring an operating state of a circuit breaker (200) **characterised in that** it is configured to carry out a probing method (100), according to one of the claims from 1 to 7.

10. Monitoring device, according to claim 9, **characterised in that** it is configured to carry out a monitoring method, according to claim 8.

11. A low-voltage electrical system (500) comprising:

- an electric line (300);

- a circuit breaker (200) electrically connected between a first line section (300A) and a second line section (300B) of said electric line (300);
- a monitoring device (1), according to claim 9 or 10, for monitoring an operating state of said circuit breaker (200), said monitoring device being electrically connected to said electric line (300) at a first point (A) of said electric line and at a second point (B) of said electric line.

FIG. 1

FIG. 2

EP 4 760 287 A1

$S_2(t) \Rightarrow$

| | |
|---|---|
| **104a** | $\Rightarrow S_3(n)$ |
| **104b** | $\Rightarrow S_J(n)$ |
| **104c** | $\Rightarrow G_{JR}(n)$ |

104

**FIG. 2A**

$S_2(t) \Rightarrow$

| | |
|---|---|
| **105a** | $\Rightarrow S_3(n)$ |
| **105b** | $\Rightarrow S_N(n)$ |
| **105c** | $\Rightarrow G_N(n)$ |

105

**FIG. 2B**

$S_2(t) \Rightarrow$

| | |
|---|---|
| **103a** | $\Rightarrow S_{3I}(t), S_{3Q}(t),$ |
| **103b** | |
| **103c** | $\Rightarrow S_3(n)$ |

**104a, 105a**

**FIG. 2C**

EP 4 760 287 A1

FIG. 3

EP 4 760 287 A1

$G_{JR}(k), G_N(k)$

**100**

151

$G_{JA}(k)$

**152**

150

**153**

*operating state
of the circuit breaker*

# FIG. 4

EP 4 760 287 A1

$G_{JA}(k)$

$V_{TH2}$

$V_{TH1}$

$t_S$

t

open or tripped state

closed state

**FIG. 5**

**EUROPEAN SEARCH REPORT**

Application Number

EP 24 22 0066

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 868 548 A1 (THALES DEUTSCHLAND GMBH [DE]) 6 May 2015 (2015-05-06) * claims 1,4; figures 3a-3e * ----- | 1-11 | INV. G01R31/327 ADD. G01R31/28 |
| A,D | EP 4 119 959 A1 (ABB SCHWEIZ AG [CH]) 18 January 2023 (2023-01-18) * claim 1 * ----- | 1-11 | |

TECHNICAL FIELDS SEARCHED (IPC)

G01R

The present search report has been drawn up for all claims

| Place of search | Date of completion of the search | Examiner |
|---|---|---|
| Munich | 30 May 2025 | Dogueri, Ali Kerem |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

......................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 22 0066

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2025

| Patent document cited in search report | | Publication date | Patent family member(s) | | Publication date |
|---|---|---|---|---|---|
| EP 2868548 | A1 | 06-05-2015 | EP | 2868548 A1 | 06-05-2015 |
| | | | ES | 2715330 T3 | 03-06-2019 |
| | | | HR | P20190357 T1 | 19-04-2019 |
| | | | PL | 2868548 T3 | 28-06-2019 |
| | | | SI | 2868548 T1 | 31-05-2019 |
| EP 4119959 | A1 | 18-01-2023 | CN | 115701004 A | 07-02-2023 |
| | | | EP | 4119959 A1 | 18-01-2023 |
| | | | US | 2023019486 A1 | 19-01-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4119959 A1